(19) Europäisches Patentamt
European Patent Office
Office européen des brevets

(11) **EP 2 703 831 B1**

(12) **EUROPEAN PATENT SPECIFICATION**

(45) Date of publication and mention
of the grant of the patent:
**05.08.2015 Bulletin 2015/32**

(51) Int Cl.:
***G01R 33/09*** *(2006.01)*      ***G01R 33/10*** *(2006.01)*
***G01R 33/00*** *(2006.01)*

(21) Application number: **12182528.5**

(22) Date of filing: **31.08.2012**

(54) **Magnetic field sensor**

Magnetfeldsensor

Capteur de champ magnétique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**05.03.2014 Bulletin 2014/10**

(73) Proprietor: **Hitachi, Ltd.**
**Tokyo (JP)**

(72) Inventors:
• **Andreev, Aleksey**
**Cambridge, Cambridgeshire CB3 0HE (GB)**
• **Takahashi, Hiromasa**
**Cambridge, Cambridgeshire CB3 0HE (GB)**
• **Hammura, Kiyotaka**
**Cambridge, Cambridgeshire CB3 0HE (GB)**
• **Williams, David**
**Cambridge, Cambridgeshire CB3 0HE (GB)**
• **Sekiguchi, Tomonori**
**Maidenhead, Berkshire SL6 8YA (GB)**
• **Ogawa, Susumu**
**Chiyoda-ku, Tokyo 100-8220 (JP)**

(74) Representative: **Piotrowicz, Pawel Jan Andrzej et al**
**Venner Shipley LLP
Byron House
Cambridge Business Park
Cowley Road
Cambridge CB4 0WZ (GB)**

(56) References cited:
**US-A1- 2009 326 337**

EP 2 703 831 B1

**Description**

The present invention relates to a magnetic field sensor.

Magnetic field sensors can be used in a wide range of applications including healthcare, electronics, automotive, security, industrial and consumer applications.

For example, G. Bison et al: "A room temperature 19-channel magnetic field mapping device for cardiac signals", Applied Physics Letters, volume 95, page 173701 (2009) describes a magnetic field imaging system formed using optical double-resonance caesium vapour magnetometers.

M. M. Miller et al.: "A DNA array sensor utilizing magnetic microbeads and magnetoelectronic detection", Journal of Magnetism and Magnetic Materials, volume 225, pages 138 - 144 (2001) describes giant magnetoresistance (GMR) magnetoelectronic sensors embedded in a chip.

S. Tumanski & S. Baranowski: "Magnetic Sensor Array For Investigations Of Magnetic Field Distribution", Journal of Electrical Engineering, volume 57, no 8/S, page 185-188 (2006) describes using arrays of magnetic sensor arrays using GMR sensors, Hall sensors and AMR sensors.

C. Hiu et al.: "A Cubic 3-Axis Magnetic Sensor Array for Wirelessly Tracking Magnet Position and Orientation", IEEE Sensors Journal, volume 10, page 903 (2010) describes a magnetic localization and orientation system.

P. Donato et al.: "Design and signal processing of a magnetic sensor array for train wheel detection", Sensors and Actuators A, volume 132, pages 516 to 525 (2006) describes a train wheel detection system based on the use of an inductive sensor array.

C. H. Smith et al: "Eddy-Current Testing With GMR Magnetic Sensor Arrays", Review of Progress in Quantitative Nondestructive Evaluation, volume 2323, pages 406 to 413 (2003) describes integrated (GMR) sensor arrays with on-chip signal processing and multiplexing.

US 2009/0326337 describes an apparatus comprising an array which comprises a plurality of nanoscale hybrid semiconductor/metal devices which are in proximity to an object. Any of a variety of nanoscale EXX sensors can be selected as the hybrid semiconductor/metal devices in the array. With such an array, ultra high resolution images of nanoscopic resolution can be generated of objects such as living cells, wherein the images are indicative of a variety of cell biologic processes.

However, these magnetic field sensors generally do not detect very small magnetic fields (B $<10^{-12}$ Tesla).

Sensors capable of detecting very small magnetic fields, such as superconducting quantum interference devices (SQUIDs), tend to suffer one or more limitations in terms of size, cost, minimum detection area, and operating temperature. These limitations prevent such sensors for being widely used in many applications.

Moreover, even magnetic field sensors capable of measuring larger, but still small, magnetic fields ($10^{-6}$ Tesla > B > $10^{-12}$ T) often cannot operate at room temperatures or higher (i.e. greater than about 293 °C) required in important applications, such as crack detection in pipes, or suffer one or more limitations.

The minimum measurable magnetic field depends on signal noise level.

Signal noise level can be reduced by taking repeated measurements. However, this results in long measurement times (or, expressed differently, low frequency operation). Thus, magnetic sensors relying on this technique may be precluded from being used in applications which require short measurement times (i.e. high frequency operation).

The present invention seeks to provide an improved magnetic field sensor.

According to a first aspect of the present invention there is provided a magnetic field sensor comprising a substrate, an array of magnetic field sensing elements supported on the substrate, each magnetic field sensing element capable of measuring a minimum measurable magnetic field at a given frequency, and means for processing the signals from the array of magnetic field sensing elements to produce an output signal such that the magnetic field sensor is capable of measuring a magnetic field at the given frequency which is lower than the minimum measurable magnetic field for an element, wherein sensitivity of any one element is maintained or improved if that element is made smaller, characterised in that the number of elements is at least $10^4$.

By using an array of magnetic field sensing elements and processing (for example, averaging) signals from the magnetic field sensing elements, it is possible to increase the minimum measurable magnetic field, $B_{min}$, of the magnetic field sensor. If there are N-magnetic field sensing elements, then the noise level can be reduced by, for example, a factor of $1\big/\sqrt{N}$ compared with a single magnetic field sensing element.

The magnetic field sensing elements may be the same or substantially the same.

The magnetic field sensing elements may have an areal density of at least $10^4$ mm$^{-2}$, at least $10^{-6}$ mm$^2$, at least $10^{-8}$ mm$^2$, or at least $10^{-10}$ mm$^2$.

Each magnetic field sensing element may comprise an extraordinary magnetoresistance device. Each extraordinary magnetoresistance device may comprise a channel, a shunt arranged along a first face (e.g. one side) of the channel and at least two leads spaced apart along a second, different face (e.g. an opposite side) of the channel. Each extraordinary magnetoresistance device may further comprise a gate running along a third, different face (e.g. top surface) of the channel, the gate comprising a gate electrode separated from the channel by a gate dielectric.

The channel may comprises silicon, for example, undoped or lightly-doped (e.g. less than about $5 \times 10^{16}$ cm$^{-3}$) silicon. The shunt may comprise heavily-doped (e.g. greater than about $1 \times 10^{18}$ cm$^{-3}$) silicon. The leads may comprise heavily-doped silicon. Thus, all or some of the device may be implemented using silicon and fabricated using known microelectronic processing techniques. The channel, shunt and/or leads may be monocrystalline or polycrystalline.

Each lead may have a length, along the channel, of no more than 100 nm, no more than 50 nm or no more than 20 nm, at a point of connection with the channel.

The device may comprise an array of cells, each cell comprising three magnetic field sensing elements, each magnetic field sensing element in a cell configured to measure a different, orthogonal component of a magnetic field.

The elements may be integrated into a single chip or wafer. Thus, the substrate may comprise at least one layer of semiconductor material (such as silicon) and/or at least one layer of dielectric material (such as silicon dioxide).

The processing means may include means for amplifying (or "amplifiers") signals from the magnetic field sensing elements. At least part of the processing means may be supported on the substrate. This can help to reduce noise. The processing means may include one or more circuits.

According to a second aspect of the present invention there is provided a magnetic image sensor comprising an array of magnetic field sensors, wherein the arrays of magnetic field sensing elements of different magnetic field sensors are supported on a common substrate. The common substrate may comprise at least one layer of semiconductor material (such as silicon) and/or at least one layer of dielectric material (such as silicon dioxide).

According to a third aspect of the present invention there is provided a method of magnetic field sensing, the method comprising receiving signals from an array of magnetic field sensing elements supported on a substrate and processing the signals from the magnetic field sensing elements to produce an output signal, wherein the number of signals processed to produce the output is at least $10^4$.

Processing the signals may comprise combining the signals. Processing the signals may comprise adding the signals. Processing the signals may comprise taking an average of the signals. The average may be a weighted average.

Certain embodiments of the present invention will now be described, by way of example, with reference to the accompanying drawings in which:

Figure 1 is a schematic block diagram of a magnetic field sensor which includes an arrangement of magnetic field sensing elements;

Figure 1a illustrates a magnetic field sensing element and a corresponding segment of the magnetic field sensor shown in Figure 1;

Figure 2 is a simplified perspective view of an arrangement of magnetic field sensing elements;

Figure 2a illustrates a square array of magnetic field sensing elements;

Figure 2b illustrates a hexagonal array of magnetic field sensing elements;

Figure 3 illustrates a magnetic field image sensor which includes an array of magnetic field sensors;

Figure 4 is a perspective view of a magnetic field sensing device in the form of an extraordinary magnetoresistance (EMR) device;

Figure 5 is a plan view of the magnetic field sensing device shown in Figure 4;

Figure 6 is plot of measured EMR device sensitivity against size;

Figure 7 is plot of numerically-simulated EMR device sensitivity against size assuming current in the device is substantially constant; and

Figure 8 are schematic plots of EMR device sensitivity against size including a first plot which assumes current in an EMR device is substantially constant and a second plot which assumes current density in an EMR device is substantially constant.

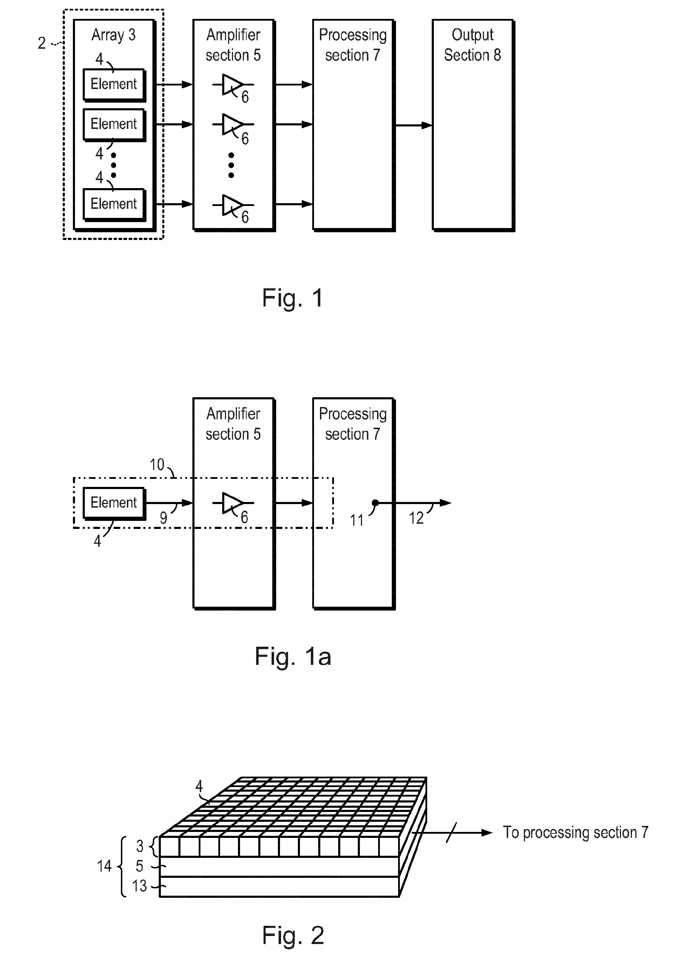

Referring to Figure 1, a magnetic field sensor 1 for measuring a magnetic field *B* in a region 2 is shown.

The device 1 includes an arrangement 3 of *N* (where *N* is a positive integer) spaced-apart magnetic field sensing elements 4 (herein also referred to simply as "field sensing elements" or even "sensing elements") occupying an area, *P*, an amplifier section 5 comprising a plurality of amplifiers 6, a processing section 7 and an output section 8.

As will be explained in more detail later, the magnetic field sensing elements 4 take the form of extraordinary magnetoresistance (EMR) devices. The number, *N*, of magnetic field sensing elements 4 is 100,000,000 (i.e. $1 \times 10^8$) and the area, *P*, is 1 mm$^2$ and so the areal density of devices is $1 \times 10^8$ mm$^{-2}$.

The magnetic field sensing elements 4 can take the form of other types of magnetoresistance, such as that described in EP 2 166 366 A1 (which is incorporated herein by reference) whose sensitivity is maintained or even improved if the element is made smaller.

Referring also to Figure 1a, a signal 9 from a magnetic field sensing element 4 is amplified and processed in a channel 10 (or "segment") which includes an amplifier 6 and is combined with signals from other channels 10 at a node 11 to produce an output signal 12.

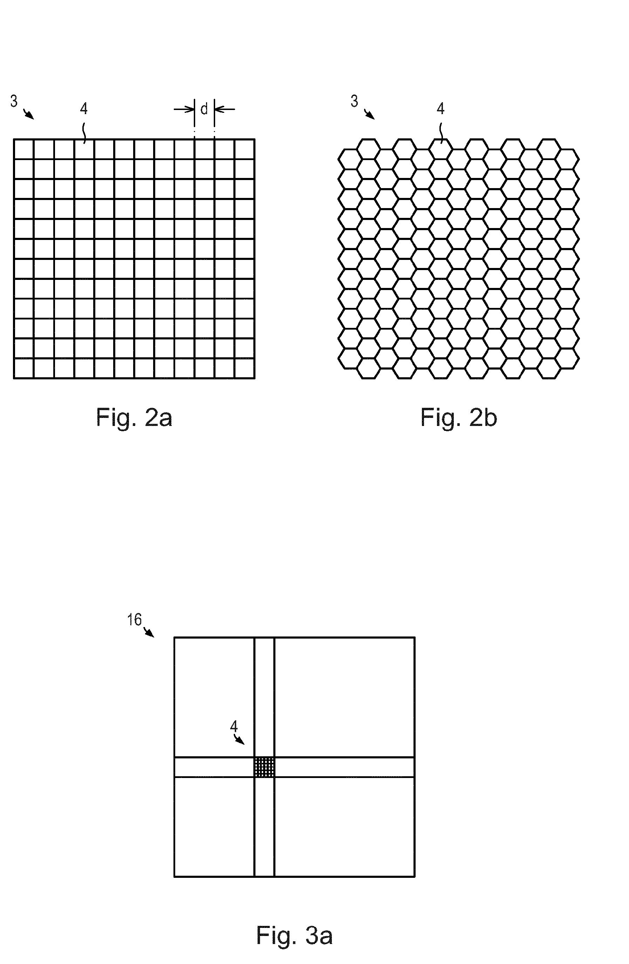

Referring also to Figure 2, the sensor arrangement 3 and the amplifier section 5 may supported on a common substrate 13 thereby forming a single integrated unit 14, such as chip, die or wafer. For example, the amplifiers 6 may take the form of transistors (not shown). In particular, each sensing element 4 may be fabricated with a corresponding transistor, for example, as described in US 2009/080118 A1. However, part or all of the amplifier section 5 may be provided in a separate unit.

The arrangement 3 takes the form of two- or three-dimensional array of sensing element 4. A two-dimensional array 3 of sensing element 4 may be arranged in a plane. A three-dimensional array of sensing element 4 can be built up as a stack of two-dimensional arrays.

Referring also to Figures 2a and 2b, the sensing element 4 may be arranged in a rectangular or hexagonal array. However, the sensing element 4 may be arranged in other regular patterns or may be arranged irregularly. In general, an arrangement 3 can be used which simplifies the interface with the amplifier section 5.

The amplifier circuit 5 is used to amplify signals output by respective sensing element 4. Each amplifier 6 within the amplifier circuit 5 can be configured to integrate a respective signal over a specified time, t. The amplifier circuit 5 may be configured to combine, for example average, the signals (or amplified signals) derived from two or more sensing element 3. The amplifier circuit 5 may include hardware-implemented arrangements for reducing noise.

The magnetic field sensor 1 may comprise three overlapping (or intermeshed) sets of magnetic field sensing elements 4 arranged to detect orthogonal components of the magnetic field. For example, three magnetic field sensing elements 4, each arranged to detect a different magnetic component, may be grouped into a cell (not shown) and cells of three elements may be arranged into an array.

The magnetic field sensor 1 is used to measure the magnetic field strength and/or magnetic field direction of a magnetic field B in a given area or volume 2 which can be represented as a point.

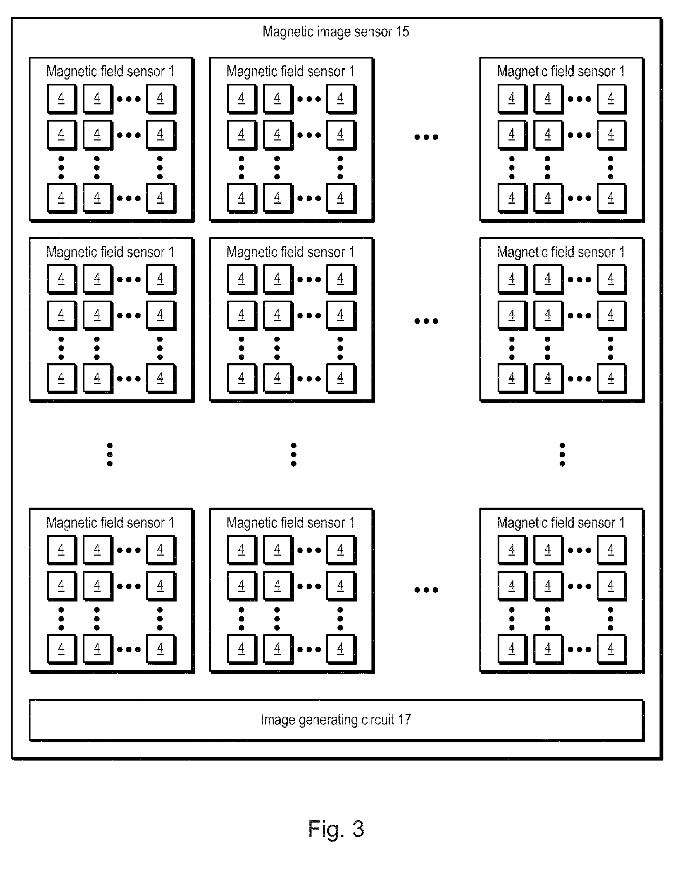

Referring also to Figures 3 and 3a, a plurality of magnetic field sensors 1 can be arranged in an array to form a magnetic image sensor 15, i.e. a device for capturing the spatial variation in magnetic field. The array 4 of magnetic field sensing devices 4 can form part of a super array 16 supported on a common substrate 13 (Figure 2). The magnetic image sensor 15 includes an image generating circuit 17 for receiving signals from individual magnetic field sensors 1 and generating an image output.

Such a magnetic image sensor 15 can be integrated into a wide variety of imaging or monitoring systems. For example, the magnetic image sensor 15 can be integrated into a garment, patch, dressing or other flexible carrier (not shown) positioned so as to monitor a heart activity.

Referring again to Figures 1, 1a and 2, the magnetic field sensing devices 4 are substantially the same (or identical), e.g. in terms of size, configuration, materials, etc., so that they have substantially the same response. Furthermore, in each segment 10, connecting lines (not shown) between and within sections 3, 5, 7, amplifiers 6 and other components (not shown) are substantially the same. For example, the dimensions (such as length) of the connecting lines and the configuration (such as the number of turns etc) of connecting lines are substantially the same. The segments 10 can be designed using memory circuit design techniques. The magnetic field sensing devices 4, amplifier section 6 and processing section 7 are arranged to minimise and preferably avoid (unwanted) correlation, for example, arising due to crosstalk.

Sensitivity, s, of a magnetic field sensing element may be defined as:

$$s = \frac{\Delta V}{\Delta B} \tag{1}$$

where $V$ is signal output and $B$ is magnetic field. If a sensor 1 has a detection area, $P$, and comprises a square array of $N$-magnetic field sensing elements 4 where $N = M^2$, then each element has a linear size, $d = \sqrt{P}/M$ or $d = $ L/M where $P = L^2$.

The behaviour of sensitivity, s, with size, $d$, of an element 4 may be described using the relation:

$$s \propto d^{\alpha} \tag{2}$$

where $\alpha$ is a scaling factor, which can be negative, zero or positive.

$\alpha = \alpha_{EMR} \leq 0$ for magnetic field sensing elements 4. In this case, sensitivity of an element 4 is substantially the same or improves as the size of the device is reduced. Herein, such an element is referred to as being "scalable". When the size of the element 4 is decreased the design of the element 4, for example geometry and relative sizes of different parts of the element, is kept substantially the same. As will be explained in more detail later, an EMR device is scalable.

In contrast, $\alpha = \alpha_{Hall} \geq 1$ for a conventional Hall sensor and so sensitivity of the Hall sensor decreases as the size of the sensor decreases. Thus, a conventional Hall sensor is not scalable. Many other magnetoresistance devices, such as giant magnetoresistance (GMR) and tunnelling magnetoresistance (TMR) devices, are non-scalable.

The magnetic field sensing devices 4 preferably do not comprise a magnetoresistance device of a type (herein referred to as a "magnetic material-based magnetoresistance device") which includes region of magnetic material and whose operation relies on switching between stable magnetization states, such as a GMR device or TMR device. Magnetic material-based magnetoresistance devices tend to suffer the problem that, as the size of the region of magnetic material is reduced, thermal noise can cause magnetisation to switch. In some embodiments of the present invention, the magnetic field sensing devices 4 may be a magnetic material-based magnetoresistance device if such thermally-induced switching does not occur.

By using an ensemble of magnetic field sensing elements 4 based on a magnetoresistance device whose sensitivity is substantially size-insensitive or improves if made smaller, the magnetic field sensor 3 can be more sensitive, as will now be described:

A magnetic field sensing element 4 produces an output signal 9 having a signal amplitude (or "level"), $a_{signal}$, and a noise amplitude (or "level"), $a_{noise}$, at a given frequency. Output signals 9 of $N$ magnetic field sensing elements 4 are combined such that the magnetic field sensor 1 produces an output signal 12 having a signal amplitude, $A_{signal}$, and noise amplitude, $A_{noise}$. The noise level, $A_{noise}$, of the magnetic field sensor 1 is given by the noise level of a magnetic field sensing element 4 divided by $\sqrt{N}$, namely:

$$A_{noise} = \frac{a_{noise}}{\sqrt{N}} \tag{3}$$

Since $N = M^2$ and $d = L/M$, then equation (3) can be expressed as:

$$A_{noise} = \frac{a_{noise}}{M} \tag{3a}$$

or

$$A_{noise} = \frac{a_{noise}\,d}{P} \tag{3b}$$

For example, if the active area (i.e. the area of detection), $P$, of the magnetic field sensor 1 is 1 mm $\times$ 1 mm, the magnetic field sensing elements 4 are arranged in an array in a single two-dimensional layer, and a magnetic field sensing element 4 occupies an area 100 nm $\times$ 100 nm such that $N = 100,000,000$ (i.e. $1\times10^8$), then the signal-to-noise ratio of the magnetic field sensor 1 is reduced by a factor of 10,000 compared with an individual magnetic field sensing element 4 for a given frequency band. The signal-to-noise ratio may reduced further if more than one two-dimensional layer is used and/or time averaging is carried out in addition to array assemble averaging.

The minimum measureable magnetic field, $B_{min}$, for the sensor 1 is determined from sensor sensitivity, S, and noise level, $A_{noise}$, where noise level, $A_{noise}$, is proportional to $1/\sqrt{N}$ $(= 1/M)$. Thus:

$$B_{min} = \frac{A_{noise}}{S} \tag{4}$$

Assuming $S \propto s$ and $s \propto d^{\alpha}$, then:

$$B_{min} \propto \frac{1/M}{d^{\alpha}} \tag{5}$$

or, since $d = L/M$ :

$$B_{min} \propto \frac{1/M}{(L/M)^{\alpha}} = \frac{1}{P^{\alpha}} M^{\alpha-1} \qquad (6)$$

Usually, the sensor area, $P$, is chosen according to the application and so can be assumed to be fixed. Thus, for scalable elements (i.e. $\alpha = 0$ or $\alpha < 0$), if the density of scalable elements is made larger (i.e. M increases) by reducing the size, $d$, of the elements, then the minimum measurable magnetic field, $B_{min}$, increases. For non-scalable elements (i.e. $\alpha = 1$ or $\alpha > 1$), if the density of elements is made larger, then the minimum measurable magnetic field, $B_{min}$, at best, stays constant and, at worst, decreases.

For other array arrangements, for example rectangular (i.e. non-square) arrays or hexagonal arrays, the arrays can be expected to follow the same or similar size-dependent behaviour depending on whether scalable or non-scalable elements are used.

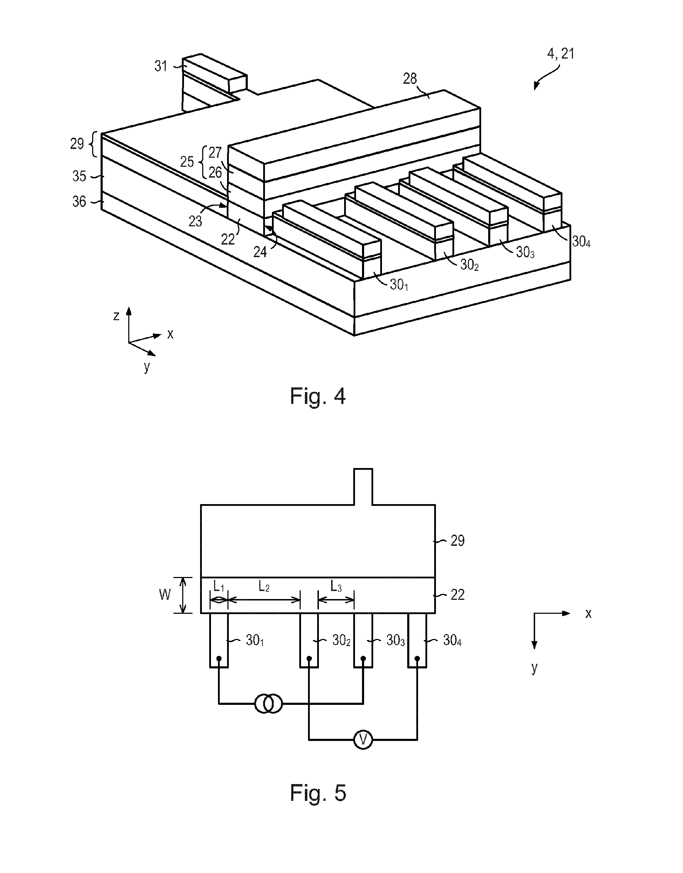

As mentioned earlier, the magnetic field sensing elements 4 comprise EMR devices. A suitable EMR device is described in EP 1 868 254 A1 which is incorporated herein by reference. Figures 4 and 5 illustrate another suitable EMR device 21.

The EMR device 21 includes an elongate channel 22 having first and second opposite sides 23, 24 and which is formed of lightly-doped ($1 \times 10^{15} cm^{-3}$) p-type polycrystalline silicon (Si). The channel 22 has a top gate arrangement 25 comprising a silicon dioxide ($SiO_2$) gate dielectric 26 using a heavily-doped ($1 \times 10^{21} cm^{-3}$) n-type polycrystalline silicon gate electrode 27. The top gate 25 is used to form an inversion layer (not shown) in the underlying p-type polycrystalline silicon. Contact to the gate electrode 27 is made via an aluminium metallization 28. The use of a top gate is described in EP 2 133 930 A.

A shunt 29 and a set of leads $30_1$, $30_2$, $30_3$, $30_4$ are arranged along the first and second sides 23, 24 of the channel 22 respectively. The shunt 29 and leads $30_1$, $30_2$, $30_3$, $30_4$ are formed of heavily-doped ($6 \times 10^{20} cm^{-3}$) n-type polycrystalline silicon and a nickel silicide (NiSi) contact. Contact to the shunt 29 and leads $30_1$, $30_2$, $30_3$, $30_4$ is made via aluminium interconnects 31, $32_1$, $32_2$, $33_3$, $34_4$.

As shown in Figure 5, the device 21 may be wired in an IVIV configuration in which current is driven between first and third leads $30_1$, $30_3$ and a potential difference is measured between the second and fourth leads $30_2$, $30_4$.

The channel 22, shunt 29 and leads $30_1$, $30_2$, $30_3$, $30_4$ are formed on a silicate glass substrate 35. A back gate is provided by aluminium metallization 36.

As shown in Figure 5, the leads $30_1$, $30_2$, $30_3$, $30_4$ each have a length, $L_1$, along the channel 22 (shown in Figure 5 orientated along an axis which is labelled as the x-axis). The first, second, third and fourth $30_1$, $30_2$, $30_3$, $30_4$ are arranged in order along the channel 22. The first and second leads $30_1$, $30_2$ are spaced apart by a length, $L_2$, such that $L_2 = 3L_1$. The second and third leads $30_2$, $30_3$ and the third and fourth leads $30_3$, $30_4$ are spaced apart by a length, $L_3$, such that $L_3 = L_1$. The channel 22 has a width, W, such that $W = L_1$. Thus, the size of the EMR device 21 can be characterized by a single parameter, namely the length, $L_1$, of the leads.

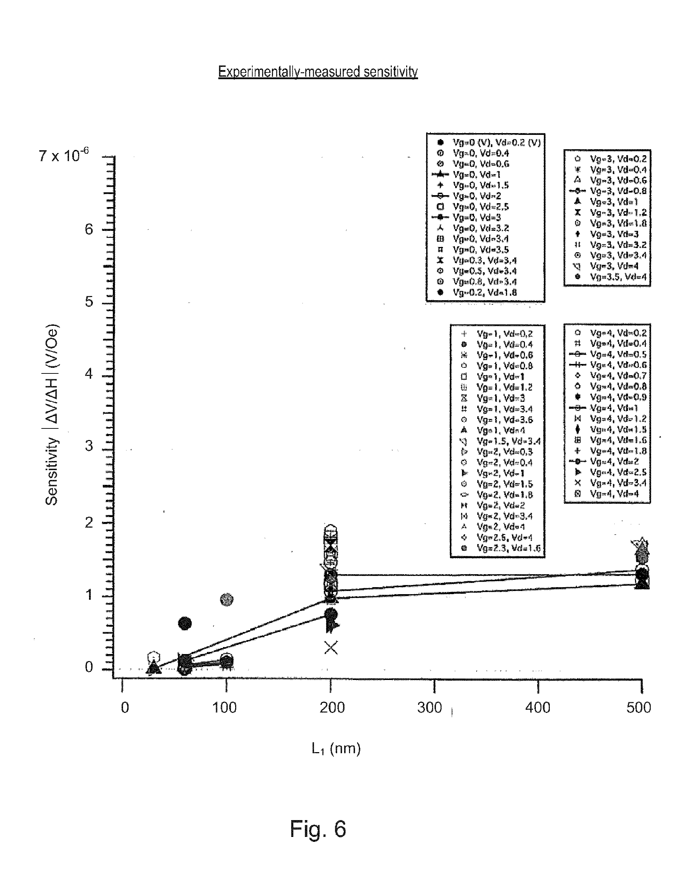

Figure 6 shows a plot of experimentally-measured sensitivity for EMR devices 21 having different values of length, $L_1$, of leads. As shown in Figure 6, the sensitivity of a device having $L_1 = 100$ nm is approximately the same as a device having $L_1 = 500$ nm. Thus, the EMR device 21 can be considered to be scalable.

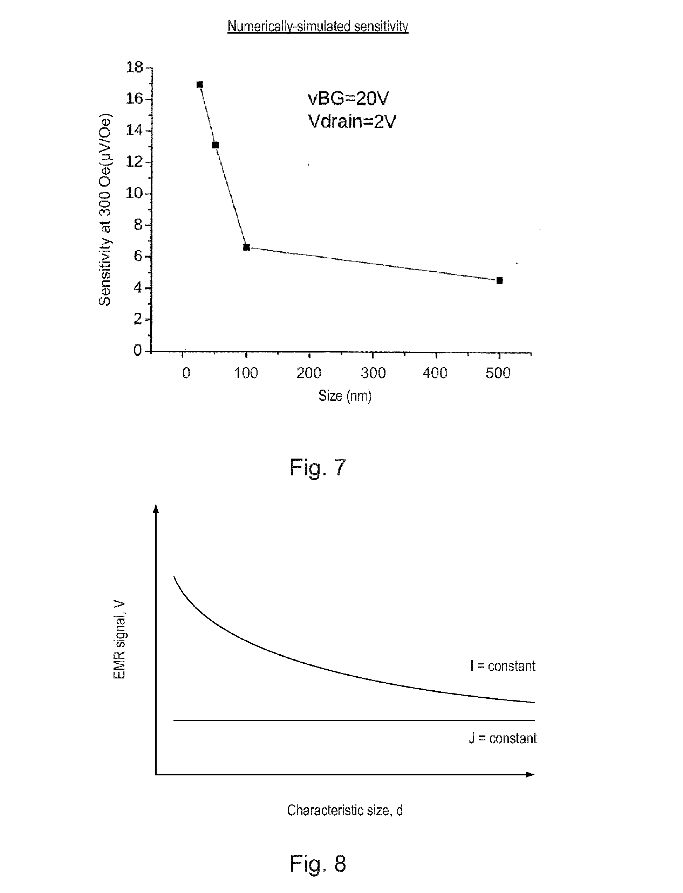

Figure 7 show a plot of a numerically-simulated sensitivity for a model of the EMR device 21. The simulated plot is obtained using SILVACO (RTM) ATLAS software.

If it is assumed that the applied voltage is constant, then the numerical simulation shows that device sensitivity (i.e. the measured signal voltage at a given magnetic field) increases as the size of the device is decreased. In this case, it appears that EMR device is behaving as a scalable device, i.e. $\alpha < 0$. However, in this case, the current-density increases and such an assumption may not be valid because of various non-linear effects such as current saturation or velocity saturation. Therefore, a more realistic assumption may be adopted and it can be assumed that current density, J, is constant. Based on this assumption, sensitivity of the EMR device is expected to be approximately constant with size, as shown in Figure 8. In this case, $\alpha = 0$.

The magnetic field sensor 1 and the magnetic image sensor 15 can be used in a wide variety of applications, especially applications involving sensing or imaging room temperature (i.e. at or above around 290 °C) or high temperatures (e.g. at or above about 400 °C).

Some applications require sensors capable of detecting magnetic fields between 1 $\mu$T and 1 nT. Thus, embodiments of sensors in accordance with the present invention could be used in automotive applications, for example to detect rotation of engine components, in non-invasive testing applications, for example crack detection in pipes and other structures found in plants, and in railway applications, for example to detect rotation of motor parts and wheels, and for diagnostics.

Some applications require sensors capable of detecting magnetic fields below 1 nT. Thus, embodiments of sensors in accordance with the present invention could be used in medicine and healthcare applications, for example magnetic imaging of internal organs, such as the heart, and in security applications, for example screening of luggage and packages.

It will be appreciated that many modifications may be made to the embodiments hereinbefore described.

The EMR device may be differently configured. For example, the relationships between $L_2$ and $L_1$, $L_3$ and $L_1$ and/or W and $L_1$ may differ.

**Claims**

1. A magnetic field sensor comprising:

    a substrate (13)
    an array (3) of magnetic field sensing elements (4) supported on the substrate, each magnetic field sensing element capable of measuring a minimum measurable magnetic field at a given frequency; and
    means (5, 7) for processing signals (9) from the array of magnetic field sensing elements to produce an output signal (12) such that the magnetic field sensor is capable of measuring a magnetic field at the given frequency which is lower than the minimum measurable magnetic field for an element,
    **characterized in that** the magnetic field sensing elements are magnetoresistance magnetic field sensing elements whose sensitivity is substantially size-insensitive or improved if that element is made smaller; and
    the number of elements is at least $10^4$.

2. A device according to claim 1, wherein the magnetic field sensing elements (4) have an areal density of at least $10^4$ $mm^2$, at least $10^6$ $mm^2$ or at least $10^8$ $mm^{-2}$.

3. A device according to any preceding claim, wherein each magnetic field sensing element (4) comprises an extraordinary magnetoresistance device (21).

4. A device according to claim 3, wherein each extraordinary magnetoresistance device (21) comprises a channel (22), a shunt (29) arranged along a first face (23) of the channel and at least two leads (30) spaced apart along a second, different face (24) of the channel.

5. A device according to claim 4, wherein each extraordinary magnetoresistance device (21) further comprises a gate (25) running along a third, different face of the channel (22), the gate comprising a gate electrode (27) separated from the channel by a gate dielectric (26).

6. A device according to claim 4 or 5, wherein the channel (22) comprises silicon.

7. A device according to any one of claims 4 to 6, wherein the shunt (29) comprises doped silicon.

8. A device according to any one of claims 4 to 7, wherein each lead (30) has a length, along the channel (22), of no more than 100 nm, no more than 50 nm or no more than 20 nm, at a point of connection with the channel.

9. A device according to any preceding claim, comprising an array (3) of cells, each cell comprising three magnetic field sensing elements (4), each magnetic field sensing element in a cell configured to measure a different, orthogonal component of a magnetic field.

10. A device according to any preceding claim, wherein the processing means (5, 7) includes means for amplifying (5) signals (9) from the magnetic field sensing elements (4).

11. A device according any preceding claim, wherein at least part of the processing means (5, 7) is supported on the substrate (13).

12. A device according to any preceding claim, wherein the processing means (5, 7) includes one or more circuits.

13. A magnetic image sensor (16) comprising:

    an array (3) of magnetic field sensors (4) according to any preceding claim;

wherein the arrays of magnetic field sensing elements of different magnetic field sensors are supported on a common substrate (13).

14. A method of magnetic field sensing, the method comprising:

receiving signals (9) from the magnetic field sensing elements according to any of claims 1-12; and
processing (5, 7) the signals from the magnetic field sensing elements to produce an output signal (12), wherein the number of signals processed to produce the output is at least $10^4$.

15. A method according to claim 14, wherein processing (5, 7) the signals (9) comprises combining the signals.

16. A method according to claim 14 or 15, wherein processing (5, 7) the signals (9) comprises averaging the signals.

**Patentansprüche**

1. Magnetfeldsensor, der Folgendes umfasst:

ein Substrat (13);
eine Gruppierung (3) von auf dem Substrat getragenen Magnetfeld-Abfühlelementen (4), wobei die Magnetfeld-Abfühlelemente jeweils fähig sind, ein minimales messbares Magnetfeld mit einer gegebenen Frequenz zu messen; und
Mittel (5, 7) zum Verarbeiten von Signalen (9) von der Gruppierung von Magnetfeld-Abfühlelementen, um ein Ausgangssignal (12) zu erzeugen, so dass der Magnetfeldsensor fähig ist, ein Magnetfeld mit der gegebenen Frequenz zu messen, das niedriger ist als das minimale messbare Magnetfeld für ein Element,
**dadurch gekennzeichnet, dass** es sich bei den Magnetfeld-Abfühlelementen um Magnetwiderstands-Magnetfeld-Abfühlelemente handelt, deren Empfindlichkeit im Wesentlichen größenunempfindlich ist oder verbessert wird, wenn das Element kleiner gemacht wird; und
die Anzahl von Elementen mindestens $10^4$ beträgt.

2. Vorrichtung nach Anspruch 1, wobei die Magnetfeld-Abfühlelemente (4) eine Flächendichte von mindestens $10^4$ mm$^{-2}$, mindestens $10^6$ mm$^{-2}$ oder mindestens $10^8$ mm$^{-2}$ aufweisen.

3. Vorrichtung nach einem der vorangehenden Ansprüche, wobei die Magnetfeld-Abfühlelemente (4) jeweils eine Extraordinary-Magnetoresistance-Vorrichtung (21) umfassen.

4. Vorrichtung nach Anspruch 3, wobei die Extraordinary-Magnetoresistance-Vorrichtungen (21) jeweils einen Kanal (22), einen entlang einer ersten Oberfläche (23) des Kanals angeordneten Nebenschluss (29) und mindestens zwei entlang einer zweiten, anderen Oberfläche (24) des Kanals voneinander beabstandete Leitungen (30) umfasst.

5. Vorrichtung nach Anspruch 4, wobei die Extraordinary-Magnetoresistance-Vorrichtungen (21) jeweils weiter ein Gate (25) umfassen, das entlang einer dritten, anderen Oberfläche des Kanals (22) verläuft, wobei das Gate eine Gate-Elektrode (27) umfasst, die durch ein Gate-Dielektrikum (26) von dem Kanal getrennt ist.

6. Vorrichtung nach Anspruch 4 oder 5, wobei der Kanal (22) Silizium umfasst.

7. Vorrichtung nach einem der Ansprüche 4 bis 6, wobei der Nebenschluss (29) dotiertes Silizium umfasst.

8. Vorrichtung nach einem der Anschlüsse 4 bis 7, wobei jede Leitung (30) an einer Verbindungsstelle mit dem Kanal eine Länge entlang dem Kanal (22) von nicht mehr als 100 nm, nicht mehr als 50 nm oder nicht mehr als 20 nm aufweist.

9. Vorrichtung nach einem der vorangehenden Ansprüche, umfassend eine Gruppierung (3) von Zellen, wobei die Zellen jeweils drei Magnetfeld-Abfühlelemente (4) umfassen und die Magnetfeld-Abfühlelemente in einer Zelle jeweils dazu konfiguriert sind, eine andere, unabhängige Komponente eines Magnetfelds zu messen.

10. Vorrichtung nach einem der vorangehenden Ansprüche, wobei die Verarbeitungsmittel (5, 7) Mittel zum Verstärken (5) von Signalen (9) von den Magnetfeld-Abfühlelementen (4) umfassen.

**11.** Vorrichtung nach einem der vorangehenden Ansprüche, wobei mindestens ein Teil der Verarbeitungsmittel (5, 7) auf dem Substrat (13) getragen wird.

**12.** Vorrichtung nach einem der vorangehenden Ansprüche, wobei die Verarbeitungsmittel (5, 7) eine oder mehr Stromkreise umfassen.

**13.** Magnetbildsensor (16), der Folgendes umfasst:

eine Gruppierung (3) von Magnetfeldsensoren (4) nach einem der vorangehenden Ansprüche; wobei die Gruppierungen von Magnetfeld-Abfühlelementen unterschiedlicher Magnetfeldsensoren auf einem gemeinsamen Substrat (13) getragen werden.

**14.** Verfahren zum Abfühlen von Magnetfeldern, wobei das Verfahren Folgendes umfasst:

Empfangen von Signalen (9) von den Magnetfeld-Abfühlelementen nach einem der Ansprüche 1-12; und Verarbeiten (5, 7) der Signale von den Magnetfeld-Abfühlelementen, um ein Ausgangssignal (12) zu erzeugen, wobei die Anzahl der zum Erzeugen des Ausgangs verarbeiteten Signale mindestens $10^4$ beträgt

**15.** Verfahren nach Anspruch 14, wobei das Verarbeiten (5, 7) der Signale (9) das Kombinieren der Signale umfasst.

**16.** Verfahren nach Anspruch 14 oder 15, wobei das Verarbeiten (5, 7) der Signale (9) das Mitteln der Signale umfasst.

**Revendications**

**1.** Capteur de champ magnétique comprenant :

un substrat (13) ;
un groupement (3) d'éléments de détection de champ magnétique (4) supportés sur le substrat, chaque élément de détection de champ magnétique étant capable de mesurer un champ magnétique mesurable minimum à une fréquence donnée, et
des moyens (5, 7) pour traiter des signaux (9) provenant du groupement d'éléments de détection de champ magnétique pour produire un signal de sortie (12) de manière à ce que le capteur de champ magnétique soit capable de mesurer un champ magnétique à la fréquence donnée qui est plus bas que le champ magnétique mesurable minimum pour un élément,
**caractérisé en ce que** les éléments de détection de champ magnétique sont des éléments de détection de champ magnétique à magnétorésistance dont la sensibilité est essentiellement insensible à la taille ou améliorée si cet élément est fait plus petit ; et
le nombre d'éléments est au moins $10^4$.

**2.** Dispositif selon la revendication 1, dans lequel les éléments de détection de champ magnétique (4) ont une densité surfacique d'au moins $10^4$ mm$^{-2}$, d'au moins $10^6$ mm$^{-2}$ ou d'au moins $10^8$ mm$^{-2}$.

**3.** Dispositif selon l'une quelconque des revendications précédentes, dans lequel chaque élément de détection de champ magnétique (4) comprend un dispositif à magnétorésistance extraordinaire (21).

**4.** Dispositif selon la revendication 3, dans lequel chaque dispositif à magnétorésistance extraordinaire (21) comprend un canal (22), un shunt (29) disposé le long d'une première face (23) du canal et au moins deux fils (30) espacés le long d'une deuxième face différente (24) du canal.

**5.** Dispositif selon la revendication 4, dans lequel chaque dispositif à magnétorésistance extraordinaire (21) comprend en outre une grille (25) s'étendant le long d'une troisième face différente du canal (22), cette grille comprenant une électrode de grille (27) séparée du canal par un diélectrique de grille (26).

**6.** Dispositif selon la revendication 4 ou 5, dans lequel le canal (22) comporte du silicium.

**7.** Dispositif selon l'une quelconque des revendications 4 à 6, dans lequel le shunt (29) comporte du silicium dopé.

8. Dispositif selon l'une quelconque des revendications 4 à 7, dans lequel chaque fil (30) a une longueur, le long du canal (22), de pas plus de 100 nm, pas plus de 50 nm ou pas plus de 20 nm, à un point de connexion avec le canal.

9. Dispositif selon l'une quelconque des revendications précédentes, comprenant un groupement (3) de cellules, chaque cellule comprenant trois éléments de détection de champ magnétique (4), chaque élément de détection de champ magnétique dans une cellule étant configuré de façon à mesurer une composante orthogonale différente d'un champ magnétique.

10. Dispositif selon l'une quelconque des revendications précédentes, dans lequel les moyens de traitement (5, 7) comprennent des moyens pour amplifier (5) les signaux (9) provenant des éléments de détection de champ magnétique (4).

11. Dispositif selon l'une quelconque des revendications précédentes, dans lequel au moins une partie des moyens de traitement (5, 7) est supportée par le substrat (13).

12. Dispositif selon l'une quelconque des revendications précédentes, dans lequel les moyens de traitement (5, 7) comprennent un ou plusieurs circuits.

13. Capteur d'image magnétique (16) comprenant :

   un groupement (3) de capteurs de champ magnétique (4) selon l'une quelconque des revendications précédentes ;
   dans lequel les groupements d'éléments de détection de champ magnétique de différents capteurs de champ magnétique sont supportés sur un substrat commun (13).

14. Procédé de détection de champ magnétique, ce procédé comprenant :

   la réception de signaux (9) provenant des éléments de détection de champ magnétique selon l'une quelconque des revendications 1 à 12 ; et
   le traitement (5, 7) des signaux provenant des éléments de détection de champ magnétique pour produire un signal de sortie (12),
   dans lequel le nombre de signaux traités pour produire la sortie est au moins $10^4$.

15. Procédé selon la revendication 14, dans lequel le traitement (5, 7) des signaux (9) comprend la combinaison des signaux.

16. Procédé selon la revendication 14 ou 15, dans lequel le traitement (5, 7) des signaux (9) comprend le moyennage des signaux.

Fig. 1

Fig. 1a

To processing section 7

Fig. 2

Fig. 2a

Fig. 2b

Fig. 3a

Fig. 3

Fig. 4

Fig. 5

Experimentally-measured sensitivity

Fig. 6

Numerically-simulated sensitivity

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20090326337 A
- EP 2166366 A1
- US 2009080118 A1
- EP 1868254 A1
- EP 2133930 A

### Non-patent literature cited in the description

- **G. BISON et al.** A room temperature 19-channel magnetic field mapping device for cardiac signals. *Applied Physics Letters,* 2009, vol. 95, 173701
- **M. M. MILLER et al.** A DNA array sensor utilizing magnetic microbeads and magnetoelectronic detection. *Journal of Magnetism and Magnetic Materials,* 2001, vol. 225, 138-144
- **S. TUMANSKI ; S. BARANOWSKI.** Magnetic Sensor Array For Investigations Of Magnetic Field Distribution. *Journal of Electrical Engineering,* 2006, vol. 57 (8/S), 185-188
- **C. HIU et al.** A Cubic 3-Axis Magnetic Sensor Array for Wirelessly Tracking Magnet Position and Orientation. *IEEE Sensors Journal,* 2010, vol. 10, 903
- **P. DONATO et al.** Design and signal processing of a magnetic sensor array for train wheel detection. *Sensors and Actuators A,* 2006, vol. 132, 516-525
- **C. H. SMITH et al.** Eddy-Current Testing With GMR Magnetic Sensor Arrays. *Review of Progress in Quantitative Nondestructive Evaluation,* 2003, vol. 2323, 406-413